# FASCICULE DE BREVET EUROPEEN

(11) **EP 1 231 563 B1**
(45) Date de publication et mention de la délivrance du brevet: **28.04.2010**
(21) Numéro de dépôt: 02290264.7
(22) Date de dépôt: 05.02.2002
(51) Int. Cl.: G06K 19/07, G11C 5/14, G06K 7/00

(54) **Alimentation asservie pour liaison serie, de type maitre esclave**
Master-slave Leistungsversorgung für serielle Verbindungen
Master-slave power feeding for serial connection links

(30) Priorité: 09.02.2001 FR 0101822
(43) Date de publication de la demande: 14.08.2002
(73) Titulaire: ATMEL NANTES SA, 44300 Nantes (FR)
(72) Inventeur: Messager, Philippe, 44000 Nantes (FR)
(74) Mandataire: Loisel, Bertrand

(56) Documents cités:
- US-A- 5 490 117
- US-A- 5 623 224
- US-A- 5 929 616

## Description

Les technologies de l'information présentent à l'heure actuelle un mode de communication entre usagers en plein essor.

Alors que les réseaux de télécommunication actuels permettent la transmission de donnes numériques dans des conditions sans cesse améliorées, tant en ce qui concerne le débit que la sécurité de la transmission, les interfaces de communication entre l'usager et la machine, terminal de communication, sont toujours soumises à des contingences matérielles vis-à-vis de la fiabilité, de la sécurité et de l'intégrité des données numériques transmises.

C'est en particulier le cas en ce qui concerne les liaisons de type série équipant les terminaux jouant le rôle d'élément maître et les circuits électroniques d'éléments, dits périphériques, tels que les cartes à microprocesseur, jouant le rôle d'élément esclave, insérés par les utilisateurs dans un lecteur de carte piloté par l'élément maître.

En particulier, dans ce type de situation, le transfert de données numériques de l'élément maître à l'élément esclave ou réciproquement reste tributaire, notamment, de la pluralité des contacts ohmiques entre plots de la carte à microprocesseur, et en outre des niveaux de tension d'alimentation appliqués à l'élément maître, respectivement esclave.

A titre d'exemple non limitatif, le schéma électrique du circuit tampon d'entrée/sortie d'un téléphone mobile ou non alimenté par un circuit d'alimentation maître et le schéma électrique d'un circuit tampon d'entrée/sortie esclave, constitué par une carte d'abonné à microprocesseur par exemple, sont alimentés à partir d'une tension d'alimentation maître Vccm, respectivement d'une tension d'alimentation esclave Vcce et sont connectés par une liaison série SL.

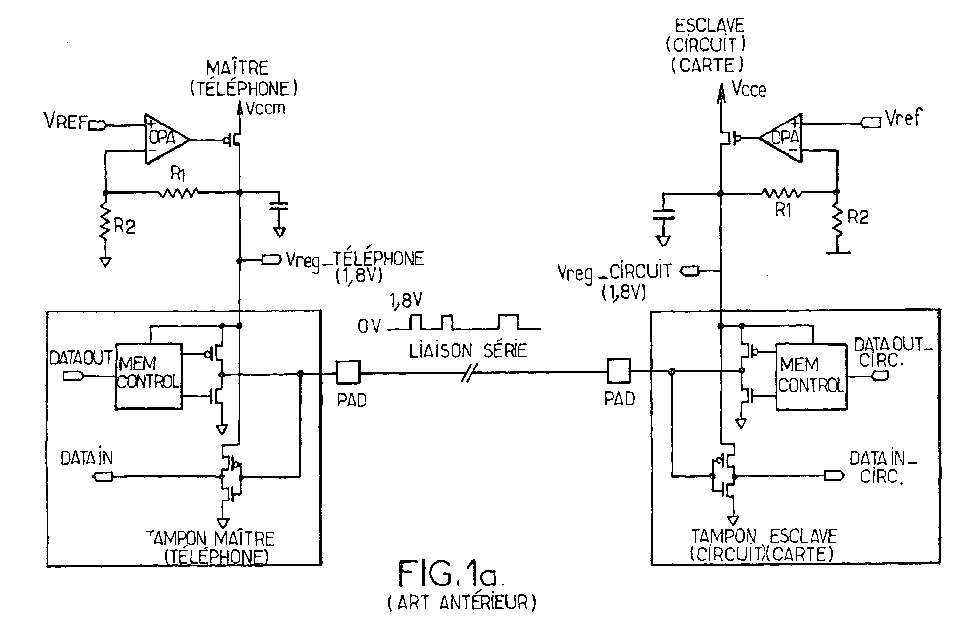

L'alimentation électrique des circuits tampon maître et esclave précités est réalisée à partir d'une tension de référence Vref, délivrée par un circuit de type "*bandgap*", lequel délivre une tension fixe. Ce type de circuit est représenté en figure 1a.

Lorsque le circuit tampon esclave, la carte, doit dialoguer avec le téléphone, par l'intermédiaire de la liaison série SL, le téléphone, jouant le rôle de l'élément maître, réveille le circuit tampon esclave par l'envoi d'impulsions de réveil. Le niveau d'amplitude de ces impulsions est de 1,8 volts, par exemple.

Le circuit tampon d'entrée/sortie maître est alimenté à partir de la tension d'alimentation maître Vccm, par l'intermédiaire d'un circuit multiplieur actif, recevant la tension de référence Vref, un amplificateur différentiel OPA dont la borne d'entrée positive est reliée à cette tension de référence formant valeur de consigne, un transistor de régulation, jouant le rôle de résistance variable commandée en tension par la sortie de l'amplificateur différentiel OPA. Ce transistor de régulation est connecté entre la tension d'alimentation maître Vccm et un point de sortie de tension d'alimentation régulée maître, une capacité de lissage connectée entre le point de sortie de la tension d'alimentation régulée maître et la tension de masse du dispositif de l'élément maître et un point diviseur R₁, R₂ reliant le point de sortie de la tension d'alimentation régulée maître à l'entrée négative de l'amplificateur différentiel. Pour un rapport de résistances R₁, R₂ donné, on obtient à l'équilibre une valeur de sortie de tension d'alimentation régulée maître inférieure à la valeur de la tension d'alimentation maître Vccm mais supérieure à la valeur de la tension de référence Vref.

Typiquement, pour une tension de référence Vref = 1,25 volts, on obtient une valeur de sortie de tension d'alimentation régulée de 1,8 volts alimentant le circuit tampon d'entrée/sortie maître.

Dans les conditions normales de fonctionnement, en présence de bons contacts ohmiques, pourvu toutefois que la tension de référence maître VREF et la tension de référence esclave Vref, les résistances R₁ respectivement R₂ maître et esclave soient égales et donc que la valeur crête des signaux numériques de sortie maîtres soit identique à la tension d'alimentation régulée esclave, un tel mode opératoire garantit des signaux numériques d'entrée/sortie maîtres respectivement esclaves sensiblement de même valeur crête et de même amplitude.

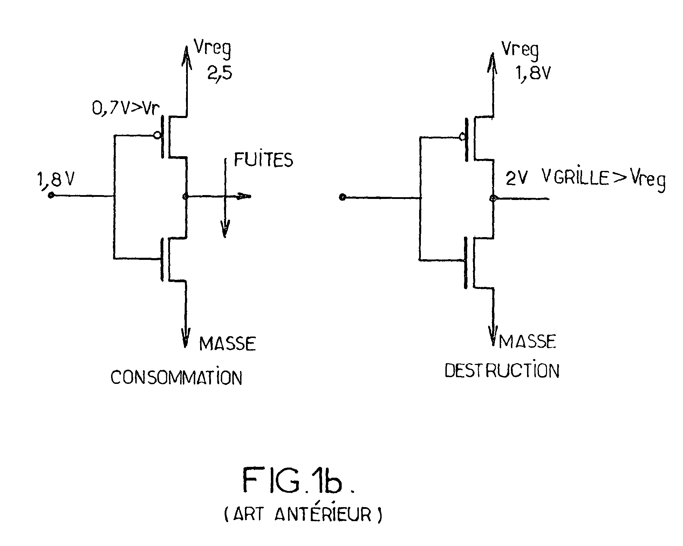

Toutefois, en raison d'un déséquilibre des rapports de tension VREF/Vref et des résistances R₁ ou R₂ maître et esclave, les conditions normales précitées ne sont pas toujours obtenues, ce qui provoque une dégradation de la valeur crête et de l'amplitude des signaux numériques d'entrée/sortie des circuits tampons maître, respectivement esclave. En outre, lorsque les valeurs de tension d'alimentation maître respectivement esclave sont distinctes et différentes, le risque de désadaptation de l'amplitude des signaux numériques d'entrée/sortie des circuits tampons précités est accru, un risque de consommation accrue et de destruction des circuits d'alimentation esclaves par le phénomène dit de *"départ* en *latch-up"* correspondant à un verrouillage d'appel de courant susceptible de détruire les transistors bipolaires. Ces risques sont illustrés en figure 1b.

Le document US 5490117 décrit un circuit d'interfaçage d'une carte à circuit intégré avec les circuits de connexion et d'alimentation d'un système hôte, permettant d'assurer la protection du circuit intégré de la carte à circuit intégré lorsque les circuits de connexion du système hôte délivrent une tension d'alimentation pouvant être égale à 3,3V ou 5V, en fonction du type de standard du système hôte considéré.

Dans le but d'assurer la compatibilité et la protection du circuit intégré de la carte à circuit intégré précitée, le circuit d'interfaçage mis en oeuvre exécute une commutation de circuit, suite à la détection de la valeur de la tension d'alimentation délivrée par le système hôte et de la comparaison de cette valeur à une valeur de seuil intermédiaire aux valeurs extrêmes de tension d'alimentation susceptibles d'être délivrées.

En conséquence, bien qu'un tel circuit d'interfaçage permette d'assurer la protection désirée, il ne permet toutefois d'alimenter le circuit intégré qu'à une valeur de tension nominale spécifique assurant le fonctionnement et la protection de ce dernier.

Il ne permet aucunement d'asservir la tension régulée esclave à une valeur représentative de la valeur crête des signaux numériques de sortie maîtres. La présente invention a pour objet de remédier aux inconvénients précités des circuits de l'art antérieur, par la mise en oeuvre d'un circuit de régulation de l'alimentation d'un élément esclave relié à un élément maître par une liaison série, ce circuit de régulation permettant d'asservir la tension d'alimentation régulée esclave asservie à la valeur crête des signaux numériques de sortie maîtres, ce qui permet de supprimer tout risque de dégradation ou de destruction des circuits esclaves et en plus de s'adapter automatiquement à tout type de téléphone 1,8 V ; 2,7 V ; 3,3 V sans changer le circuit esclave.

Un autre objet de la présente invention est également, du fait de l'asservissement précité de la tension d'alimentation régulée esclave à la valeur crête des signaux numériques de sortie maître, la mise en oeuvre d'un circuit d'alimentation régulée esclave de structure sensiblement simplifié, dans lequel tout générateur de tension de référence de type "band-gap" est supprimé.

L'alimentation asservie pour liaison d'un élément esclave relié à un élément maître par une liaison série, objet de la présente invention, est définie dans la revendication 1.

Le module de régulation esclave de la tension électrique d'alimentation est remarquable en ce qu'il comporte, d'une part, un module d'échantillonnage et de détection de la valeur crête des signaux numériques de sortie maîtres reçus par l'intermédiaire de la liaison série, ce module d'échantillonnage et de détection délivrant une valeur crête échantillonnée des signaux numériques de sortie maîtres, et, d'autre part, un module d'asservissement suiveur de la tension d'alimentation esclave des circuits d'entrée et de sortie esclaves à une valeur sensiblement égale à celle de la valeur crête échantillonnée des signaux de sortie maîtres. Le module de régulation esclave de la tension électrique d'alimentation permet de délivrer des signaux numériques de sortie esclaves d'amplitude crête sensiblement adaptée à l'amplitude crête les signaux numériques de sortie maîtres.

L'alimentation asservie et le module de régulation esclave de la tension d'alimentation, objets de la présente invention, trouvent application à la réalisation de circuits d'alimentation électriques d'équipements de télécommunication tels que téléphones mobiles ou fixes et leurs cartes à microprocesseur d'équipement, sous forme de circuits intégrés de type CMOS.

L'alimentation asservie et le module de régulation esclave de la tension d'alimentation, objets de l'invention, seront mieux compris à la lecture de la description et à l'observation des dessins ci-après dans lesquels, outre les figures 1a et 1b relatives à l'art antérieur :
- la figure 2 représente, à titre illustratif, une alimentation asservie et un module de régulation esclave de la tension d'alimentation, objets de la présente invention ;
- la figure 3a représente un chronogramme des signaux relevés aux points de test A et B de la figure 2 et illustrant les signaux numériques respectivement les signaux numériques maîtres inversés ;
- la figure 3b représente un chronogramme des signaux relevés aux points de test C, D et E de figure 2 engendrés en synchronisme des signaux relevés aux points de test A et B de la figure 2, selon la figure 3a ;
- la figure 3c représente une vue dilatée en amplitude des signaux relevés aux points de test C et E de la figure 2, cette vue dilatée permettant la mise en évidence d'erreurs d'asservissement en amplitude n'excédant pas 3mV.

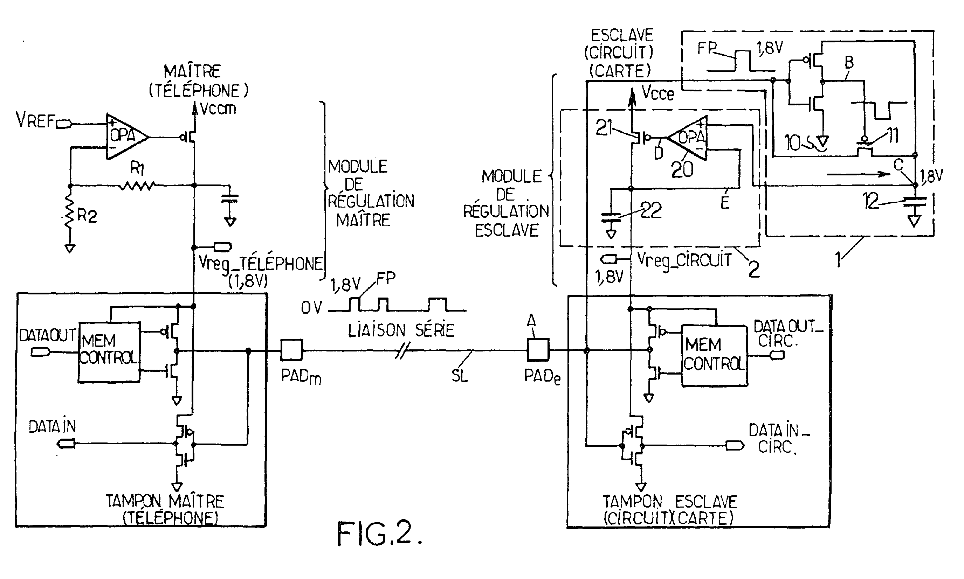

Une description plus détaillée de l'alimentation asservie pour liaison série de type maître/esclave et en particulier d'un module de régulation esclave de la tension d'alimentation électrique d'un élément esclave relié à un élément maître par une liaison série, selon l'invention, sera maintenant donnée en liaison avec la figure 2 et les figures suivantes.

En référence à la figure précitée, on indique qu'un élément maître tel qu'un téléphone mobile par exemple ou, le cas échéant, un téléphone fixe est relié à un élément esclave par une liaison série notée SL sur la figure 2.

D'une manière générale, on indique que l'élément maître, constitué par le téléphone, comporte un module de régulation maître de la tension d'alimentation électrique d'un circuit de sortie maître, ce circuit de sortie maître étant constitué par un circuit tampon maître tel que représenté sur la figure 2. Ce circuit de sortie maître délivre des signaux numériques de sortie maîtres alors qu'un circuit d'entrée maître reçoit des signaux numériques de sortie esclaves, par l'intermédiaire de la même liaison série SL.

On comprend, bien entendu, que l'élément maître est alimenté en énergie électrique par un système de régulation d'alimentation électrique à partir d'une tension d'alimentation maître notée Vccm. De manière plus spécifique et non limitative, on indique que le dispositif de régulation de l'élément maître peut avantageusement correspondre à celui de l'art antérieur tel que décrit précédemment en liaison avec la figure la lequel, pour cette raison, ne sera pas décrit de manière plus détaillée.

D'une manière plus spécifique, l'élément esclave comporte, alimenté par une tension d'alimentation esclave notée Vcce, un circuit d'entrée esclave recevant les signaux numériques de sortie maîtres par l'intermédiaire de la liaison série SL et un circuit de sortie esclave délivrant les signaux numériques de sortie esclaves. Le circuit d'entrée et le circuit de sortie esclave sont constitués, ainsi que représenté sur la figure 2, par un tampon esclave l'élément esclave pouvant correspondre à une carte téléphonique telle qu'une carte à microprocesseur par exemple.

D'une manière générale, on rappelle que les circuits tampons maître et esclave comportent chacun une mémoire tampon de contrôle MEM CONTROL recevant les données de sortie, notées DATAOUT pour les données de sortie maîtres transmises par l'intermédiaire d'un inverseur sur la borne de sortie PAD maîtres, et une mémoire de contrôle esclave recevant les données de sortie du circuit ou carte constitutif de l'élément esclave, ces données de sortie étant notées DATAOUT_circ. La mémoire de contrôle esclave délivre également les signaux numériques de sortie esclaves par l'intermédiaire d'un inverseur à la borne de sortie PAD , les bornes de sortie maîtres respectivement esclaves étant reliées par la liaison série SL. Chaque circuit tampon maître respectivement esclave comporte en outre un inverseur connecté aux bornes de sortie maîtres respectivement esclaves et permettant de délivrer les signaux numériques d'entrée maîtres notés DATAIN respectivement esclaves DATAIN_circ.

Bien entendu, les circuits tampons maîtres respectivement esclaves sont alimentés à partir de la tension d'alimentation maître Vccm respectivement esclave Vcce par l'intermédiaire d'un module de régulation maître respectivement esclave, lesquels seront décrits ci-après.

Le module de régulation maître correspond au module de régulation de l'art antérieur décrit en liaison avec la figure 1a et délivre une tension d'alimentation maître régulée notée Vreg_téléphone laquelle, dans l'exemple d'application non limitatif correspondant, est sensiblement égale à 1,8 volts. Cette tension alimente, bien entendu, le circuit tampon maître.

Conformément à un aspect particulièrement remarquable de l'alimentation asservie objet de la présente invention, on indique que le module de régulation esclave de la tension d'alimentation électrique du tampon esclave comprend avantageusement un module 1 d'échantillonnage et de détection de la valeur crête des signaux numériques de sortie maîtres reçus par l'intermédiaire de la liaison série SL. Le module d'échantillonnage et de détection 1 délivre une valeur crête échantillonnée des signaux numériques de sortie maîtres.

Le module de régulation esclave comporte en outre un circuit suiveur 2 d'asservissement de la tension d'alimentation esclave des circuits d'entrée et de sortie esclaves à une valeur sensiblement égale à celle de la valeur crête échantillonnée des signaux de sortie maîtres. Sur la figure 2, la tension d'alimentation esclave permettant l'alimentation du circuit tampon esclave est notée Vreg_circuit. Le circuit suiveur 2 d'asservissement permet, grâce à l'alimentation du circuit tampon esclave à partir de la tension d'alimentation esclave régulée Vreg_circuit, de délivrer des signaux numériques de sortie esclaves d'amplitude crête sensiblement adaptée à celle des signaux numériques de sortie maîtres.

Un mode de réalisation préférentiel non limitatif des différents éléments constitutifs du module de régulation esclave représenté en figure 2 sera maintenant décrit en liaison avec la figure précitée.

En ce qui concerne le module 1 d'échantillonnage et de détection de la valeur crête des signaux numériques de sortie maîtres, ceux-ci peuvent comporter avantageusement un circuit détecteur constitué par un inverseur dont l'entrée est connectée à l'entrée du circuit d'entrée esclave c'est à dire à la borne de l'entrée PADe, ce circuit détecteur recevant ainsi les signaux numériques de sortie maîtres par l'intermédiaire de la liaison série SL. Le circuit détecteur constitué par l'inverseur peut être réalisé en technologie CMOS à partir de deux transistors PMOS respectivement NMOS connectés en connexion série DRAIN source, source DRAIN et dont l'électrode de grille, connecté en parallèle, est reliée à la borne d'entrée de l'élément esclave PADe ainsi que représenté sur la figure 2.

En outre, le module 1 d'échantillonnage et de détection comporte un circuit de mémorisation de valeur crête des signaux numériques de sortie maîtres, ce circuit étant formé avantageusement par un circuit interrupteur 11 constitué par un transistor de type PMOS par exemple dont l'entrée est connectée à l'entrée du circuit esclave recevant ainsi des signaux numériques de sortie maîtres et dont la borne de commande d'interruption est connectée en sortie de l'inverseur constitutif du circuit détecteur. Ainsi, la borne de commande d'interruption du circuit interrupteur 11 est commandée par les signaux numériques de sortie maîtres inversés, délivrés par l'inverseur précité. La borne de sortie du circuit interrupteur 11 délivre des signaux numériques de sortie maîtres échantillonnés.

Un condensateur de mémorisation et de filtrage est prévu portant la référence 12, ce condensateur de mémorisation étant connecté entre la sortie du circuit interrupteur 11 et la tension de masse de l'élément esclave.

En outre, en référence à la figure 2, le circuit d'asservissement 2 de la tension d'alimentation esclave comporte avantageusement un amplificateur différentiel OPA, noté 20, dont la borne d'entrée positive est connectée à la borne de détection de la valeur crête du condensateur de mémorisation 12 et dont la borne négative est connectée à la borne d'alimentation du circuit de sortie esclave délivrant en fait la tension d'alimentation régulée Vreg_circuit du circuit tampon esclave, cette tension de sortie d'alimentation régulée étant prise comme tension d'alimentation asservie. La borne de sortie de l'amplificateur différentiel 20 délivre une tension de commande vis-à-vis de la tension d'alimentation régulée du circuit de sortie esclave.

En outre, le circuit d'asservissement 2 comporte un transistor de régulation 21 dont la borne d'entrée est reliée à la tension d'alimentation esclave Vcce et dont la borne de commande, c'est à dire la borne de grille, est reliée à la borne de sortie de l'amplificateur différentiel 20. La borne de commande du transistor 21 c'est à dire sa borne de grille est ainsi commandée par la tension de commande délivrée par l'amplificateur différentiel 20, cette tension de commande permettant ainsi de réguler la tension d'alimentation régulée au circuit de sortie esclave.

Un condensateur de lissage de la tension d'alimentation régulée du circuit de sortie esclave, c'est à dire de la tension Vreg_circuit, est prévu, ce condensateur 22 étant connecté entre la borne de sortie du circuit d'asservissement 2 délivrant la tension d'alimentation régulée du circuit de sortie esclave Vreg_circuit et la tension de masse de l'élément esclave.

Le fonctionnement du module de régulation esclave, peut être résumé de la manière ci-après :
Sur apparition d'une impulsion délivrée par la liaison série SL, en particulier d'un train d'impulsion de réveil de l'élément esclave par l'élément maître, dès l'apparition de la première impulsion d'amplitude 1,8 volts, cette première impulsion étant notée FP sur la figure 2, l'inverseur 10 constituant le circuit détecteur est déclenché et le signal numérique maître inversé correspondant délivré en sortie de l'inverseur précité provoque la commande du transistor 11 constitutif du module interrupteur pour assurer l'échantillonnage de la valeur crête de l'impulsion précitée. Le transistor interrupteur 11 étant commandé à l'état passant, un courant de charge provoque la charge du condensateur de mémorisation 12 à la valeur d'amplitude crête 1,8 volts de la première impulsion FP. Sur apparition de la tension de crête mémorisée aux bornes du condensateur 12, l'amplificateur différentiel 20 provoque alors, à partir de cette tension mémorisée prise comme valeur de consigne, l'asservissement de la valeur de la tension d'alimentation régulée Vreg_circuit à la valeur de consigne précitée par l'intermédiaire du transistor de régulation 21, lequel, commandé par la sortie de l'amplificateur différentiel 20, joue le rôle d'une résistance ajustable commandée en tension et permettant d'assurer l'asservissement de la valeur de la tension d'alimentation régulée précitée délivrée par le circuit d'asservissement 2 à la valeur de consigne, c'est à dire à la valeur mémorisée par le condensateur 12.

Lors de la disparition de la première impulsion FP, l'interrupteur constitué par le transistor 11 est alors ramené à l'état bloqué et la valeur de tension crête mémorisée au niveau de la capacité 12 est maintenue, la valeur de la tension d'alimentation régulée Vreg_circuit délivrée par le circuit d'asservissement 2 étant maintenue, dans ces conditions, à la valeur d'amplitude crête antérieure. Bien entendu, sur apparition d'une nouvelle impulsion, le processus est renouvelé, ce qui permet d'assurer un suivi de la tension d'alimentation régulée esclave, délivrée au circuit tampon esclave, et en particulier au circuit de sortie esclave, à la valeur exacte de l'amplitude crête des impulsions constitutives des signaux numériques maîtres reçus sur la borne d'entrée PADe de l'élément esclave.

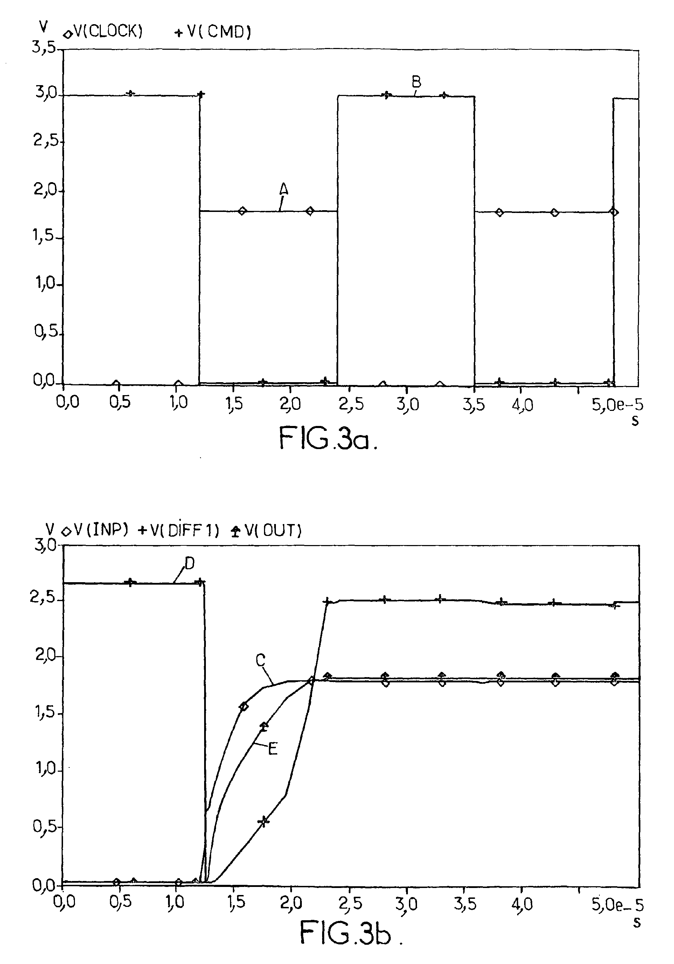

Des chronogrammes spécifiques, relevés aux points de test A, B, C, D, E de la figure 2, sont représentés aux figures 3a,3b respectivement 3c.

Pour les figures précitées, on indique en référence à la figure 2 que le point de test A est le point de test correspondant à la borne d'entrée de la liaison série SL de l'élément esclave c'est à dire la borne PADe :
- le point de test B correspond au point de sortie de l'inverseur 10 constitutif du circuit détecteur délivrant les signaux numériques maîtres inversés ;
- le point de test C correspond à la borne du condensateur de mémorisation 12 recevant la valeur d'amplitude crête mémorisée et délivrant cette valeur à la borne positive de l'amplificateur différentiel 20 ;
- le point de test D correspond à la borne de sortie de l'amplificateur opérationnel 20 relié à la borne de commande du transistor de régulation 21 ;
- le point de test E correspond à la borne de sortie du circuit d'asservissement 2 délivrant la tension d'alimentation régulée Vreg_circuit ainsi qu'à la tension appliquée à la borne négative de l'amplificateur différentiel 20.

Sur la figure 3a, on a représenté respectivement un signal correspondant à la première impulsion FP relevé au point de test A représentatif des signaux numériques maîtres d'entrée et des signaux numériques maîtres inversés relevés au point de test B délivrés par la sortie de l'inverseur 10.

Sur la figure 3b, on a représenté en correspondance chronologique avec les signaux représentés en figure 3a :
- la tension de crête mémorisée par le condensateur de mémorisation 12 au point de test C ;
- la tension délivrée par la sortie de l'amplificateur différentiel 20 au point de test D, c'est à dire sur la borne de grille d'un transistor de régulation 21 ;
- la tension d'alimentation régulée esclave, c'est à dire la tension Vreg_circuit délivrée par la sortie du circuit d'asservissement 2 au point de test E.
Sur les figures 3a et 3b, l'axe des abscisses est gradué en dizaines de micro-secondes et l'axe des ordonnées en volts.

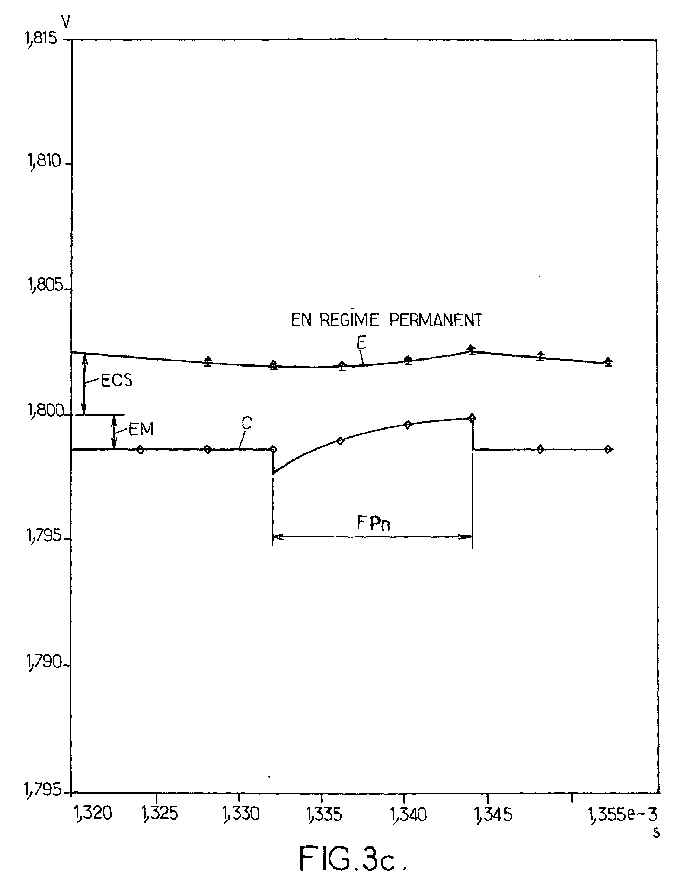

Sur la figure 3c, on a représenté à échelle dilatée sur l'axe des ordonnées, c'est à dire en amplitude, respectivement en échelle contractée sur l'axe des abscisses ou échelle temporelle, d'une part, le signal disponible aux bornes du condensateur de mémorisation 12 c'est à dire sur la borne positive de l'amplificateur différentiel 20 au point de test C et la tension d'alimentation régulée esclave, c'est à dire la tension Vreg_circuit, disponible au point de test E, d'autre part.

Les deux tensions précitées sont représentées en référence à la première impulsion FP₁ du signal disponible sur la liaison série SL pour les figures 3a et 3b et à une impulsion FPₙ de rang n en régime établi sur la figure 3c.

A l'observation de la figure 3c, on peut constater, d'une part, que pour une tension d'alimentation régulée maître égale à 1,8 volts à partir par exemple d'une tension de référence de 1,25 volt délivrée par un circuit de type "*band-gap*", l'erreur de mémorisation EM au point de test C, par rapport à la valeur 1,8 volt précitée, n'excède pas 1,5 millivolt en régime permanent alors que sur apparition de la première impulsion FP₁ où finalement d'une impulsion suivante FPₙ sur la liaison série SL, l'amplitude de variation de la tension mémorisée aux bornes du condensateur 12 et finalement appliquée à la borne positive de l'amplificateur différentiel 20 n'excède pas ± 1,5 millivolt, ce qui permet d'assurer une précision dynamique de l'amplitude crête mémorisée n'excédant pas 2/1000.

De la même manière, l'observation de la figure 3c montre que la tension d'alimentation régulée esclave c'est à dire la tension Vreg_circuit présente, en régime permanent, une erreur moyenne ECS due à l'erreur introduite par le circuit suiveur (constitué par le circuit d'asservissement 2) n'excédant pas 3 millivolts.

## Revendications

1. Alimentation asservie, pour liaison d'un élément esclave relié à un élément maître par une liaison série (SL), l'alimentation asservie étant formée par :
l'élément maître comportant un module de régulation maître de la tension d'alimentation électrique (Vccm) d'un circuit de sortie maître, délivrant des signaux numériques de sortie maîtres, et d'un circuit d'entrée maître, recevant des signaux numériques de sortie esclaves par l'intermédiaire de cette liaison série (SL), et par :
l'élément esclave comportant, alimentés par une tension d'alimentation électrique esclave (Vcce), un circuit d'entrée esclave recevant les signaux numériques de sortie maîtres par l'intermédiaire de cette liaison série (SL), un circuit de sortie esclave délivrant les signaux numériques de sortie esclaves et un module de régulation esclave de la tension d'alimentation électrique (Vcce) des circuits d'entrée et de sortie esclaves, **caractérisée en ce que** ledit module de régulation esclave de la tension d'alimentation électrique (Vcce) comporte :
• des moyens (1) d'échantillonnage et de détection de la valeur crête desdits signaux numériques de sortie maîtres reçus par l'intermédiaire de ladite liaison série (SL), lesdits moyens (1) d'échantillonnage et de détection délivrant une valeur crête échantillonnée desdits signaux numériques de sortie maîtres ;
• des moyens (2) d'asservissement de ladite tension d'alimentation esclave (Vcce) desdits circuits d'entrée et de sortie esclaves à une valeur sensiblement égale à celle de la valeur crête échantillonnée desdits signaux de sortie maîtres, ce qui permet de délivrer des signaux numériques de sortie esclaves d'amplitude crête sensiblement adaptée à l'amplitude crête des signaux numériques de sortie maîtres.

2. Alimentation asservie selon la revendication 1, **caractérisée en ce que** lesdits moyens (1) d'échantillonnage et de détection de la valeur crête des signaux numériques de sortie maîtres comportent au moins :
• un circuit détecteur, dont l'entrée est connectée à l'entrée du circuit d'entrée esclave recevant les signaux numériques de sortie maîtres par l'intermédiaire de cette liaison série (SL) et dont la sortie (B) délivre des signaux numériques de sortie maîtres inversés ;
• un circuit de mémorisation (11, 12) de valeur crête des signaux numériques de sortie maîtres et comportant :
- un module interrupteur (11) dont l'entrée est connectée à l'entrée du circuit esclave recevant les signaux numériques de sortie maîtres, dont la borne de commande d'interruption est connectée en sortie (B) dudit circuit inverseur et commandée par lesdits signaux numériques de sortie maîtres inversés et dont la borne de sortie délivre (C) des signaux numériques de sortie maîtres échantillonnés, et
- un condensateur (12) de mémorisation de la valeur crête connecté entre la sortie dudit module interrupteur et la tension de masse.

3. Alimentation asservie selon l'une des revendications 1 ou 2, **caractérisée en ce que** lesdits moyens (2) d'asservissement de ladite tension d'alimentation esclave (Vcce) comportent :
• un amplificateur différentiel (20) dont la borne d'entrée positive est connectée à la borne de détection (C) de la valeur crête dudit condensateur de mémorisation, dont la borne négative est connectée à la borne d'alimentation dudit circuit de sortie esclave délivrant une tension d'alimentation régulée (Vreg-CIRCUIT) du circuit esclave prise comme tension d'alimentation asservie et dont la sortie (D) délivre une tension de commande vis-à-vis de la tension d'alimentation régulée du circuit de sortie esclave ;
• un transistor de régulation (21) dont la borne d'entrée est reliée à la tension d'alimentation esclave (Vcce) , dont la borne de commande est reliée à la borne de sortie (D) de l'amplificateur différentiel et commandée par ladite tension de commande vis-à-vis de la tension d'alimentation régulée du circuit de sortie esclave, ledit transistor de régulation (21) délivrant, audit circuit de sortie esclave, ladite tension d'alimentation régulée (Vreg-CIRCUIT) du circuit de sortie esclave asservie à la valeur crête des signaux numériques de sortie maîtres.

## Claims

1. Slaved supply, for linking a slave element linked to a master element by a serial link, the slave supply being formed by:
the master element comprising a master module for regulating the electrical supply voltage (Vccm) of a master output circuit, delivering master digital output signals, and of a master input circuit, receiving slave digital output signals by way of this serial link (SL), and by:
the slave element comprising, supplied by a slave electrical supply voltage (Vcce), a slave input circuit receiving the master digital output signals by way of this serial link (SL), a slave output circuit delivering the slave digital output signals and a slave module for regulating the electrical supply voltage (Vcce) of the slave input and output circuits, **characterized in that** the said slave module for regulating the electrical supply voltage (Vcce) comprises:
• means (1) for sampling and for detecting the peak value of the said master digital output signals received by way of the said serial link (SL), the said sampling and detecting means (1) delivering a sampled peak value of the said master digital output signals;
• means (2) for slaving the said slave supply voltage (Vcce) of the said slave input and output circuits to a value substantially equal to that of the sampled peak value of the said master output signals, thereby making it possible to deliver slave digital output signals whose peak amplitude is substantially matched to the peak amplitude of the master digital output signals.

2. Slaved supply according to Claim 1, **characterized in that** the said means (1) for sampling and for detecting the peak value of the master digital output signals comprise at least:
• a detector circuit, whose input is connected to the input of the slave input circuit receiving the master digital output signals by way of this serial link (SL) and whose output (B) delivers inverted master digital output signals;
• a circuit (11, 12) for storing the peak value of the master digital output signals and comprising:
- an interrupter module (11) whose input is connected to the input of the slave circuit receiving the master digital output signals, whose interrupt control terminal is connected at the output (B) of the said inverter circuit and controlled by the said inverted master digital output signals and whose output terminal delivers (C) sampled master digital output signals, and
- a peak value storage capacitor (12) connected between the output of the said interrupter module and the earth voltage.

3. Slaved supply according to one of Claims 1 or 2, **characterized in that** the said means (2) for slaving the said slave supply voltage (Vcce) comprise:
• a differential amplifier (20) whose positive input terminal is connected to the peak value detection terminal (C) of the said storage capacitor, whose negative terminal is connected to the supply terminal of the said slave output circuit delivering a regulated supply voltage (Vreg-CIRCUIT) of the slave circuit taken as slaved supply voltage and whose output (D) delivers a control voltage with regard to the regulated supply voltage of the slave output circuit;
• a regulating transistor (21) whose input terminal is linked to the slave supply voltage (Vcce), whose control terminal is linked to the output terminal (D) of the differential amplifier and controlled by the said control voltage with regard to the regulated supply voltage of the slave output circuit, the said regulating transistor (21) delivering, to the said slave output circuit, the said regulated supply voltage (Vreg-CIRCUIT) of the slave output circuit, slaved to the peak value of the master digital output signals.

## Patentansprüche

1. Geregelte Versorgung zur Verbindung eines mit einem Master-Element verknüpften Slave-Elements über eine serielle Verbindung (SL), wobei die geregelte Versorgung durch Folgendes gebildet wird:
das Master-Element, das ein Master-Regulierungsmodul der elektrischen Versorgungsspannung (Vccm) einer Master-Ausgangsschaltung, die digitale Master-Ausgangssignale zustellt, und eine Master-Eingangschaltung, die digitale Slave-Ausgangssignale über einen Vermittler dieser seriellen Verbindung (SL) empfängt, aufweist, und
das Slave-Element eine Slave-Eingangsschaltung, die die digitalen Master-Ausgangssignale über den Vermittler dieser seriellen Verbindung (SL) empfängt, eine Slave-Ausgangsschaltung, die die digitalen Slave-Ausgangssignale zustellt, und ein Slave-Regulierungsmodul der elektrischen Versorgungsspannung (Vcce) von Slave-Eingangs- und Ausgangsschaltungen aufweist, die durch eine elektrische Slave-Versorgungsspannung (Vcce) versorgt werden, **dadurch gekennzeichnet, dass** das Slave-Regulierungsmodul der elektrischen Versorgungsspannung (Vcce) Folgendes aufweist:
Einrichtungen (1) zur Abtastung und zur Erfassung des Scheitelwerts der durch den Vermittler der seriellen Verbindung (SL) empfangenen digitalen Master-Ausgangssignale, wobei die Einrichtungen (1) zur Abtastung und Erfassung einen abgetasteten Scheitelwert der digitalen Master-Ausgangssignale zustellen;
Einrichtungen (2) zur Rückführung der Slave-Versorgungsspannung (Vcce) der Slave-Eingangs- und Ausgangsschaltungen zu einem Wert, der etwa dem abgetasteten Scheitelwert der Master-Ausgangssignale entspricht, wodurch zugelassen wird, dass digitale Slave-Ausgangssignale einer Scheitelamplitude, die etwa an die Scheitelamplitude der digitalen Master-Ausgangssignale angepasst ist, zugestellt werden.

2. Geregelte Versorgung nach Anspruch 1, wobei die Einrichtungen (1) zur Abtastung und zur Erfassung des Scheitelwerts der digitalen Master-Ausgangssignale zumindest Folgendes aufweisen:
eine Erfassungsschaltung, deren Eingang mit dem Eingang der Slave-Eingangsschaltung verbunden ist, die die digitalen Master-Ausgangssignale durch den Vermittler dieser seriellen Verbindung (SL) empfängt, und deren Ausgang (B) die invertierten digitalen Master-Ausgangssignale zustellt;
eine Schaltung (11, 12) zur Speicherung des Scheitelwerts der digitalen Master-Ausgangssignale, die Folgendes aufweist:
ein Schaltmodul (11), dessen Eingang mit dem Eingang der Slave-Schaltung verbunden ist, die die digitalen Master-Ausgangssignale empfängt, dessen Schaltsteuerung-Anschlussklemme mit dem Ausgang (B) der Invertierungsschaltung verbunden ist und durch die invertierten digitalen Master-Ausgangssignale gesteuert wird, und dessen Ausgangsanschlussklemme (C) die abgetasteten digitalen Master-Ausgangssignale zustellt, und
einen Kondensator (12) zur Speicherung des Scheitelwerts, der zwischen dem Ausgang des Schaltmoduls und der Bezugsmasse verbunden ist.

3. Geregelte Versorgung nach einem der Ansprüche 1 oder 2, wobei die Einrichtungen (2) zur Rückführung der Slave-Versorgungsspannung (Vcce) Folgendes aufweisen:
einen Differenzverstärker (20), dessen positive Eingangsanschlussklemme mit der Anschlussklemme (C) zur Erfassung des Scheitelwerts des Kondensators zur Speicherung verbunden ist, dessen negative Anschlussklemme mit der Anschlussklemme zur Versorgung der Slave-Ausgangsschaltung verbunden ist, die eine regulierte Versorgungsspannung (Vreg-CIRCUIT) der Slave-Schaltung zustellt, die als eine zugestellte Versorgungsspannung verwendet wird, und dessen Ausgang (D) eine Steuerspannung gegenüber der regulierten Versorgungsspannung der Slave-Ausgangsschaltung zustellt;
einen Regulierungstransistor (21), dessen Eingangsanschlussklemme mit der Slave-Versorgungsspannung (Vcce) verknüpft ist, dessen Steueranschlussklemme mit der Ausgangsanschlussklemme (D) des Differenzverstärkers verknüpft ist und durch die Steuerspannung gegenüber der regulierten Versorgungsspannung der Slave-Ausgangsschaltung gesteuert wird, wobei der Regulierungstransistor (21) an die Slave-Ausgangsschaltung die regulierte Versorgungsspannung (Vreg-CIRCUIT) der Slave-Ausgangsschaltung, die auf den Scheitelwert der digitalen Master-Ausgangssignale geregelt wird, zustellt.
